# EUROPEAN PATENT SPECIFICATION

(11) **EP 4 307 047 B1**
(45) Date of publication and mention of the grant of the patent: **03.06.2026**
(21) Application number: 22767000.7
(22) Date of filing: 03.03.2022
(51) Int. Cl.: G03F 1/32, G03F 1/58, G03F 1/74, G03F 1/80

(54) **PHASE SHIFT MASK BLANK, PHASE SHIFT MASK, METHOD FOR MANUFACTURING PHASE SHIFT MASK, AND METHOD FOR MODIFYING PHASE SHIFT MASK**
PHASENSCHIEBERMASKENROHLING, PHASENSCHIEBERMASKE, VERFAHREN ZUR HERSTELLUNG EINER PHASENSCHIEBERMASKE UND VERFAHREN ZUR MODIFIZIERUNG EINER PHASENSCHIEBERMASKE
ÉBAUCHE DE MASQUE À DÉCALAGE DE PHASE, MASQUE À DÉCALAGE DE PHASE, PROCÉDÉ DE FABRICATION DE MASQUE À DÉCALAGE DE PHASE ET PROCÉDÉ DE MODIFICATION DE MASQUE À DÉCALAGE DE PHASE

(30) Priority: 09.03.2021 JP 2021037722
(43) Date of publication of application: 17.01.2024
(73) Proprietor: Tekscend Photomask Corp., Tokyo 105-7133 (JP)
(72) Inventor: MATSUI, Kazuaki, Tokyo 110-0016 (JP); KUROKI, Kyoko, Tokyo 110-0016 (JP); KOJIMA, Yosuke, Tokyo 110-0016 (JP)
(74) Representative: Hoffmann Eitle
(86) International application number: PCT/JP2022/009232
(87) International publication number: WO 2022/191042

(56) References cited:
- WO-A1-2017/169658
- WO-A1-2018/056033
- WO-A1-2019/188397
- JP-A- 2015 184 453
- JP-A- 2016 035 559

## Description

### Technical Field

The present invention relates to a phase shift mask blank, a phase shift mask, a method for manufacturing a phase shift mask, and a method for modifying a phase shift mask that are used for manufacturing semiconductor devices and the like.

### Background Art

Recently, in semiconductor processing, nanofabrication of a circuit pattern has been required particularly along with high integration of a large scale integrated circuit, and a demand for a nanofabrication technology of interconnection patterns or contact hole patterns configuring the circuit has increased.
Therefore, as an exposure light source used for manufacturing semiconductor devices and the like, shifting to a shorter wavelength from a KrF excimer laser (wavelength: 248 nm) to an ArF excimer laser (wavelength: 193 nm) has progressed.

In addition, as a mask for improving wafer transfer characteristics, for example, a phase shift mask is used. In the phase shift mask, in order that a phase difference between ArF excimer laser light that transmits through a transparent substrate and ArF excimer laser light that transmits through both of a transparent substrate and a phase shift film (hereinafter, simply referred to as "phase difference") is 180 degrees and to adjust a ratio of the amount of ArF excimer laser light that transmits through both of a transparent substrate and a phase shift film to the amount of ArF excimer laser light that transmits through a transparent substrate (hereinafter, simply referred to as "transmittance") is 6%, both of the phase difference and the transmittance can be adjusted.

For example, a method is known, in which when the phase shift mask where the phase difference is 180 degrees is manufactured, after setting the film thickness of the phase shift film such that the phase difference is about 177 degrees, a transparent substrate is processed into about 3 nm while dry etching the phase shift film with fluorine-based gas, and finally the phase difference is adjusted to about 180 degrees.

In a phase shift mask to which exposure light having a wavelength of 200 nm or less is applied, foreign matter called "haze" is gradually formed, grown, and visualized by exposure, and the mask cannot be used. In particular, when the phase shift film is a film including silicon, transition metal, and a light element such as oxygen or nitrogen, foreign matter may be formed on the phase shift film surface.

Technologies for suppressing the haze are described in, for example, PTLs 1 and 2.

However, in the technologies described in PTLs 1 and 2, the effect of suppressing the above-described haze may be insufficient. A **further phase shift** mask blank forming part of the prior art can be found in WO 2018/056033 A1.

### Citation List

### Patent Literatures

PTL 1: JP 2018-173621 A
PTL 2: JP 4579728 B

### Summary of Invention

### Technical Problem

The present invention has been made under the above-described circumstances, and an object thereof is to provide a phase shift mask blank that can sufficiently suppress the formation of haze on a phase shift film surface (on a phase mask), a phase shift mask having reduced haze defects, a method for manufacturing the phase shift mask, and a method for modifying the phase shift mask by electron beam modification etching.

### Solution to Problem

The present invention has been made in order to achieve the object, and according to one aspect of the present invention, there is provided a phase shift mask blank used for producing a phase shift mask to which exposure light having a wavelength of 200 nm or less is applied, the phase shift mask blank including: a transparent substrate; a phase shift film formed on the transparent substrate; and a light shielding film formed on the phase shift film, in which the phase shift film is a multi-layer phase shift film in which a plurality of phase difference and transmittance adjustment layers that are capable of adjusting a predetermined amount of each of a phase and a transmittance with respect to exposure light to be transmitted and a plurality of protective layers against gas permeation configured to prevent gas permeation to the phase difference and transmittance adjustment layers are alternately deposited, and a modification etching rate during electron beam modification of the protective layer against gas permeation is higher than a modification etching rate of the phase difference and transmittance adjustment layer.

In addition, according to another aspect of the present invention, there is provided a phase shift mask having a circuit pattern to which exposure light having a wavelength of 200 nm or less is applied, the phase shift mask including: a transparent substrate; a phase shift film formed on the transparent substrate; and a light shielding film formed on the phase shift film, in which the phase shift film is a multi-layer phase shift film in which a plurality of phase difference and transmittance adjustment layers that are capable of adjusting a predetermined amount of each of a phase and a transmittance with respect to exposure light to be transmitted and a plurality of protective layers against gas permeation configured to prevent gas permeation to the phase difference and transmittance adjustment layers are alternately deposited, and a modification etching rate during electron beam modification of the protective layer against gas permeation is higher than a modification etching rate of the phase difference and transmittance adjustment layer.

In addition, according to still another aspect of the present invention, there is provided a method for manufacturing a phase shift mask using the above-described phase shift mask blank, the method including: a step of forming a light shielding film on the phase shift film; a step of forming a resist pattern on the light shielding film; a step of forming a pattern on the light shielding film by oxygen-containing chlorine-based etching (Cl/O-based) after forming the resist pattern; a step of forming a pattern on the phase shift film by fluorine-based etching (F-based) after forming the pattern on the light shielding film; a step of removing the resist pattern after forming the pattern on the phase shift film; and a step of removing the light shielding film by oxygen-containing chlorine-based etching (Cl/O-based) from the phase shift film after removing the resist pattern.

In addition, according to still another aspect of the present invention, there is provided a method for modifying the phase shift mask by electron beam modification etching, the method including: surface-oxidizing each of the protective layers against gas permeation immediately before modifying the protective layers against gas permeation.

### Advantageous Effects of Invention

By using the phase shift mask blank according to the aspect of the present invention, the formation of haze on the phase shift mask can be sufficiently suppressed, and it is easy to modify the phase shift mask by electron beam modification etching.

### Brief Description of Drawings

FIG. 1 is a schematic cross-sectional view illustrating a configuration of a phase shift mask blank according to an embodiment of the present invention;
FIG. 2 is a schematic cross-sectional view illustrating a configuration of a phase shift mask according to an embodiment of the present invention;
FIG. 3 is a schematic cross-sectional view illustrating side etching after electron beam modification etching a single-layer phase shift film;
FIG. 4 is a schematic cross-sectional view illustrating side etching after electron beam modification etching a phase shift film of the phase shift mask according to the embodiment of the present invention;
FIG. 5 is an enlarged schematic cross-sectional view illustrating side etching in the middle of electron beam modification etching a phase shift film of the phase shift mask according to the embodiment of the present invention;
FIG. 6 is a schematic cross-sectional view illustrating steps of manufacturing a phase shift mask using the phase shift mask blank according to the embodiment of the present invention;
FIG. 7 is a schematic cross-sectional view illustrating a modification example of side etching after electron beam modification etching a phase shift film of the phase shift mask according to the embodiment of the present invention;
FIGS. 8A and 8B are a schematic plan view and a schematic cross-sectional view illustrating a structure before a modification step of a phase shift mask according to an example of the present invention;
FIG. 9 is a schematic cross-sectional view illustrating the modification step of the phase shift mask according to the example of the present invention;
FIG. 10 is a schematic cross-sectional view illustrating the modification step of the phase shift mask according to the example of the present invention; and
FIGS. 11A and 11B are a schematic plan view and a schematic cross-sectional view illustrating a structure after the modification step of the phase shift mask according to the example of the present invention.

### Description of Embodiments

The present inventors thought that, unless conditions of three elements including a constituent material of a phase adjustment film (a phase difference and transmittance adjustment layer described below) configuring a phase shift mask blank or a phase shift mask, moisture or an oxidizing gas such as oxygen, and exposure energy are satisfied, the formation of haze in the mask blank or the mask can be reduced, thereby completing a phase shift mask blank or a phase shift mask having the following configuration. That is, the phase shift mask blank, the phase shift mask, and method for manufacturing the phase shift mask according to the present embodiment are based on a technical idea that, by providing a gas protective layer (a so-called gas barrier layer) on a phase adjustment film, the constituent material of the phase adjustment film is prevented from coming into contact with the oxidizing gas such that the formation of haze is reduced.

Embodiments of the present invention will be described with reference to the following drawings. A schematic cross-sectional view does not exactly reflect an actual dimensional ratio or the number of patterns, and the digging amount of a transparent substrate or the damage amount of a film is not illustrated. Examples of a preferable embodiment of the phase shift mask blank according to the present invention include the following aspect.

### (Overall Configuration of Phase Shift Mask Blank)

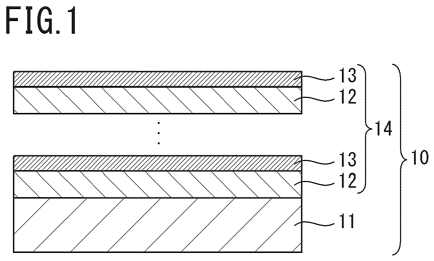

FIG. 1 is a schematic cross-sectional view illustrating a configuration of a phase shift mask blank according to an embodiment of the present invention. A phase shift mask blank 10 illustrated in FIG. 1 is a phase shift mask blank used for producing a phase shift mask to which exposure light having a wavelength of 200 nm or less is applied, the phase shift mask blank including: a substrate (hereinafter, also simply referred to as "substrate") 11 that is transparent with respect to the exposure wavelength; and a phase shift film 14 formed on the substrate 11. In addition, the phase shift film 14 is a multi-layer phase shift film in which a plurality of phase difference and transmittance adjustment layers (hereinafter, also simply referred to as "phase layers") 12 that are capable of adjusting a predetermined amount of each of a phase and a transmittance with respect to exposure light to be transmitted and a plurality of protective layers against gas permeation (hereinafter, simply referred to as "protective layers") 13 configured to prevent gas permeation to the phase difference and transmittance adjustment layers 12 are alternately deposited, the protective layer against gas permeation 13 being formed on the phase difference and transmittance adjustment layer 12. In addition, a modification etching rate during electron beam modification of the protective layer 13 is higher than a modification etching rate of the phase layer 12.

In addition, it is preferable that the lowermost layer of the phase shift film 14, that is, a layer that is closest to the substrate 11 is the phase layer 12. In addition, it is preferable that the outermost layer of the phase shift film 14, that is, a layer that is farthest from the substrate 11 is the protective layer 13. Hereinafter, each of the layers configuring the phase shift mask blank 10 according to an embodiment of the present invention will be described in detail.

### (Substrate)

The substrate 11 is not particularly limited. As the substrate 11, for example, quartz glass, CaF₂, or aluminosilicate glass is generally used.

### (Phase Shift Film)

The phase shift film 14 is a multi-layer phase shift film in which a plurality of the phase layers 12 and a plurality of the protective layers 13 are alternately deposited, and is formed on the substrate 11 with or without another film interposed.

The phase shift film 14 is, for example, a film that has resistance to oxygen-containing chlorine-based etching (Cl/O-based) and is etchable by fluorine-based etching (F-based).

A value of the transmittance of the phase shift film 14 is in a range of, for example, 3% or more and 80% or less with respect to the transmittance of the substrate 11, and an optimum transmittance can be appropriately selected for a desired wafer pattern. In addition, the value of the phase difference of the phase shift film 14 is in a range of, for example, 160 degrees or more and 220 degrees or less and is more preferably in a range of 175 degrees or more and 190 degrees or less. That is, in the phase shift film 14, the transmittance with respect to the exposure light may be in a range of 3% or more and 80% or less, and the phase difference may be in a range of 160 degrees or more and 220 degrees or less. When the transmittance is less than 3% with respect to the exposure light of the phase shift film 14, there may be a case where favorable exposure performance cannot be obtained. In addition, when the phase difference is in a range of 160 degrees or more and 220 degrees or less, required exposure performance can be easily maintained.

### <Phase Layer>

The phase layer 12 is a layer formed on the substrate 11 or the protective layer 13 with or without another film interposed and is capable of adjusting a predetermined amount of each of a phase and a transmittance with respect to exposure light to be transmitted. Here, "adjusting the phase" refers to, for example, inverting the phase. In addition, "transmittance" refers to the transmittance with respect to the exposure light.

In addition, the phase layer 12 is a layer that has resistance with respect to oxygen-containing chlorine-based (Cl/O-based) gas etching, is etchable with fluorine-based gas (F-based), and can be modified by an electron beam (EB) modification method.

The phase layer 12 is, for example, a single-layer film that contains silicon and contains at least one selected from transition metal, nitrogen, oxygen, and carbon, a multi-layer film or a graded film thereof, and a layer where the transmittance and the phase difference with respect to the exposure wavelength are adjusted by appropriately selecting a composition and a film thickness. Here, "the graded film" refers to a film where a composition ratio between components (materials) configuring the phase layer 12 changes at a given ratio, not a film where the entire composition of the phase layer 12 is uniform.

In an element ratio of the entire phase layer 12, the content of silicon is preferably in a range of 20 at% or more and 60 at% or less, the content of transition metal is preferably in a range of 0 at% or more and 20 at% or less, the content of nitrogen is preferably in a range of 30 at% or more and 80 at% or less, the content of oxygen is preferably in a range of 0 at% or more and 30 at% or less, and the content of carbon is preferably in a range of 0 at% or more and 10 at% or less. As a more preferable range of the content of each of the elements in the phase layer 12, in the element ratio of the entire phase layer 12, the content of silicon is preferably in a range of 30 at% or more and 50 at% or less, the content of transition metal is preferably in a range of 0 at% or more and 10 at% or less, the content of nitrogen is preferably in a range of 40 at% or more and 70 at% or less, the content of oxygen is preferably in a range of 0 at% or more and 20 at% or less, and the content of carbon is preferably in a range of 0 at% or more and 5 at% or less. When the content of each of the elements in the phase layer 12 is in the above-described numerical range, not only the transmittance but also the phase difference of the phase layer 12 can be easily controlled.

In addition, the phase layer 12 may contain at least one of an oxide, a carbide, and a nitride of metal silicide. In this case, the metal configuring the metal silicide may be transition metal described below.

The transition metal in the phase layer 12 is preferably at least one selected from molybdenum, titanium, vanadium, cobalt, nickel, zirconium, niobium, and hafnium and is more preferable molybdenum. When the transition metal in the phase layer 12 is at least one selected from molybdenum, titanium, vanadium, cobalt, nickel, zirconium, niobium, and hafnium, the processing of the phase layer 12 is easy, and when the transition metal in the phase layer 12 is molybdenum, the processability during the etching of the phase layer 12 is further improved.

A film thickness of each of the phase layers 12 is preferably 0.5 nm or more, and the sum of the film thicknesses of the phase layers 12 is preferably more than the sum of the film thicknesses of the protective layers 13. When the film thickness of each of the phase layers 12 is less than 0.5 nm, the effect of the phase shift cannot be obtained. In addition, the film thickness of the phase layer 12 is preferably 0.5 nm or more in consideration of a film forming limit of the phase layer 12 in a film forming method such as sputtering. In addition, when the sum of the film thicknesses of the phase layers 12 is less than the sum of the film thicknesses of the protective layers 13, the ratio of the phase layers 12 to the entire phase shift film 14 is relatively reduced, and thus the effect of the phase shift is not likely to be obtained.

The film thicknesses of the phase layers 12 may be the same as or different from each other. When the film thicknesses of the phase layers 12 are different from each other, it is easy to adjust the total value of the film thicknesses of the phase layers 12. When the film thicknesses of the phase layers 12 are the same as each other, the accuracy of the total value of the film thicknesses of the phase layers 12 is improved.

In addition, as described above, the phase shift film 14 includes the plurality of phase layers 12. However, film kinds (the kind of the constituent material or the composition ratio) of the phase layers 12 may be the same as or different from each other. For example, the kinds of the transition metals in the phase layers 12 may be different from or the same as each other. When the kinds of the transition metals in the phase layers 12 are different from each other, a specific function can be given to each of the layers, that is, the functions can be separately given to the respective layers. In addition, when the kinds of the transition metals in the phase layers 12 are the same as each other, film forming conditions of the phase layers 12 are the same, and thus the film properties (physical properties) of the phase layers 12 are uniform.

### <Protective Layer>

The protective layer 13 is a layer formed on the phase layer 12 with or without another film interposed and prevents and suppresses gas permeation (in particular, permeation of moisture or an oxidizing gas such as oxygen) to the phase layer 12, that is, a gas barrier layer. In the present embodiment, the permeation of the gas that is considered to be one element for the formation of haze to the phase layer 12 can be prevented and suppressed. Therefore, even when the mask is used for a long period of time (for example, when a dosage on the mask exceeds 100 kJ/cm²), the formation of haze on the phase shift mask surface can be prevented and suppressed.

The gas (atmosphere gas) that prevents and suppresses the permeation in the protective layer 13 is oxidizing gas, specifically oxygen-containing molecules, and more specifically water molecules.

In addition, the protective layer 13 is a layer that has resistance with respect to oxygen-containing chlorine-based (Cl/O-based) gas etching, is etchable with fluorine-based gas (F-based), and can be modified by an electron beam (EB) modification method.

The protective layer 13 is preferably a single-layer film that includes one or more compounds selected from tantalum metal, a tantalum compound, tungsten metal, a tungsten compound, tellurium metal, and a tellurium compound, a mixed film of the compounds, or a multi-layer film of the compounds. However, the protective layer 13 is not particularly limited in composition as long as the protective layer 13 is a layer having a barrier function. The tantalum metal, the tungsten metal, and the tellurium metal refer to a simple substance of each of the metals.

The protective layer 13 including the tantalum compound is a single-layer film that contains tantalum and one or more elements selected from oxygen, nitrogen, and carbon or is a multi-layer film or a graded film thereof.

In the protective layer 13 including the tantalum compound, in an element ratio of the entire protective layer 13, the content of tantalum is preferably in a range of 10 at% or more and 90 at% or less, the content of oxygen is preferably in a range of 0 at% or more and 90 at% or less, the content of nitrogen is preferably in a range of 0 at% or more and 70 at% or less, and the content of carbon is preferably in a range of 0 at% or more and 20 at% or less. As a more preferable range of the content of each of the elements in the protective layer 13 including the tantalum compound, in the element ratio of the entire protective layer 13, the content of tantalum is preferably in a range of 20 at% or more and 80 at% or less, the content of oxygen is preferably in a range of 0 at% or more and 80 at% or less, the content of nitrogen is preferably in a range of 0 at% or more and 60 at% or less, and the content of carbon is preferably in a range of 0 at% or more and 10 at% or less. When the content of each of the elements in the protective layer 13 including the tantalum compound is in the above-described numerical range, the barrier performance of the gas permeation of the protective layer 13 to the phase layer 12 is improved.

In addition, the protective layer 13 including the tungsten compound is a single-layer film that contains tungsten and one or more elements selected from oxygen, nitrogen, and carbon or is a multi-layer film or a graded film thereof.

In the protective layer 13 including the tungsten compound, in an element ratio of the entire protective layer 13, the content of tungsten is preferably in a range of 10 at% or more and 70 at% or less, the content of oxygen is preferably in a range of 30 at% or more and 90 at% or less, the content of nitrogen is preferably in a range of 0 at% or more and 20 at% or less, and the content of carbon is preferably in a range of 0 at% or more and 20 at% or less. As a more preferable range of the content of each of the elements in the protective layer 13 including the tungsten compound, in the element ratio of the entire protective layer 13, the content of tungsten is preferably in a range of 20 at% or more and 60 at% or less, the content of oxygen is preferably in a range of 50 at% or more and 80 at% or less, the content of nitrogen is preferably in a range of 0 at% or more and 10 at% or less, and the content of carbon is preferably in a range of 0 at% or more and 10 at% or less. When the content of each of the elements in the protective layer 13 including the tungsten compound is in the above-described numerical range, the barrier performance of the gas permeation of the protective layer 13 to the phase layer 12 is improved.

In addition, the protective layer 13 including the tellurium compound is a single-layer film that contains tellurium and one or more elements selected from oxygen, nitrogen, and carbon or is a multi-layer film or a graded film thereof.

In the protective layer 13 including the tellurium compound, in an element ratio of the entire protective layer 13, the content of tellurium is preferably in a range of 20 at% or more and 70 at% or less, the content of oxygen is preferably in a range of 30 at% or more and 90 at% or less, the content of nitrogen is preferably in a range of 0 at% or more and 20 at% or less, and the content of carbon is preferably in a range of 0 at% or more and 20 at% or less. As a more preferable range of the content of each of the elements in the protective layer 13 including the tellurium compound, in the element ratio of the entire protective layer 13, the content of tellurium is preferably in a range of 30 at% or more and 60 at% or less, the content of oxygen is preferably in a range of 50 at% or more and 80 at% or less, the content of nitrogen is preferably in a range of 0 at% or more and 10 at% or less, and the content of carbon is preferably in a range of 0 at% or more and 10 at% or less. When the content of each of the elements in the protective layer 13 including the tellurium compound is in the above-described numerical range, the barrier performance of the gas permeation of the protective layer 13 to the phase layer 12 is improved.

As described above, when the protective layer 13 is a single-layer film that includes one or more compounds selected from tantalum metal, a tantalum compound, tungsten metal, a tungsten compound, tellurium metal, and a tellurium compound, a mixed film of the compounds, or a multi-layer film of the compounds, the gas permeation to the phase layer 12 can be effectively prevented.

A film thickness of each of the protective layers 13 is preferably 0.5 nm or more, and the sum of the film thicknesses of the protective layers 13 is preferably 30 nm or less. When the film thickness of each of the protective layers 13 is less than 0.5 nm, the film thickness of the protective layer 13 is excessively small, and the possibility of a decrease in gas barrier performance increases. In addition, the film thickness of the protective layer 13 is preferably 0.5 nm or more in consideration of a film forming limit of the protective layer 13 in a film forming method such as sputtering. In addition, when the sum of the film thicknesses of the protective layers 13 is more than 30 nm, the ratio of the phase layers 12 to the entire phase shift film 14 is relatively reduced, and thus the effect of the phase shift is not likely to be obtained.

The film thicknesses of the protective layers 13 may be the same as or different from each other. When the film thicknesses of the protective layers 13 are different from each other, it is easy to adjust the total value of the film thicknesses of the protective layers 13. When the film thicknesses of the protective layers 13 are the same as each other, the accuracy of the total value of the film thicknesses of the protective layers 13 is improved.

In addition, as described above, the phase shift film 14 includes the plurality of protective layers 13. However, film kinds (the kind of the constituent material or the composition ratio) of the protective layers 13 may be the same as or different from each other. For example, the kinds of the metal elements in the protective layers 13 may be different from or the same as each other. When the kinds of the metal elements in the protective layers 13 are different from each other, a specific function can be given to each of the layers, that is, the functions can be separately given to the respective layers. In addition, when the kinds of the metal elements in the protective layers 13 are the same as each other, film forming conditions of the protective layers 13 are the same, and thus the film properties (physical properties) of the protective layers 13 are uniform.

### (Overall Configuration of Phase Shift Mask)

Hereinafter, a configuration of a phase shift mask 100 according to an embodiment of the present invention will be described in detail.

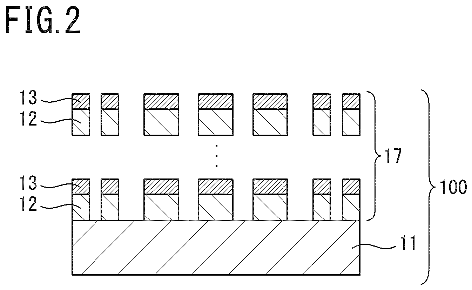

FIG. 2 is a schematic cross-sectional view illustrating a configuration of the phase shift mask according to an embodiment of the present invention. The phase shift mask 100 illustrated in FIG. 2 is a phase shift mask (that is, a patterned phase shift mask) having a circuit pattern to which exposure light having a wavelength of 200 nm or less is applied, the phase shift mask 100 including: a substrate 11 that is transparent with respect to the exposure wavelength; and a phase shift film 14 formed on the substrate 11. In addition, the phase shift film 14 is a multi-layer phase shift film in which a plurality of phase layers 12 that are capable of adjusting a predetermined amount of each of a phase and a transmittance with respect to exposure light to be transmitted and a plurality of protective layers 13 configured to prevent gas permeation to the phase layers 12 are alternately deposited, the protective layer 13 being formed on the phase layer 12. In addition, a modification etching rate during electron beam modification of the protective layer 13 is higher than a modification etching rate of the phase layer 12.

In addition, it is preferable that the lowermost layer of the phase shift film 14, that is, a layer that is closest to the substrate 11 is the phase layer 12. In addition, it is preferable that the outermost layer of the phase shift film 14, that is, a layer that is farthest from the substrate 11 is the protective layer 13.

The phase shift mask 100 includes a phase shift film pattern 17 formed by removing a part of the phase shift film 14 to expose the surface of the substrate 11.

The composition and the like of each of the layers configuring the phase shift mask 100 according to the embodiment of the present invention are the same as the composition and the like of each of the layers configuring the phase shift mask blank 10 according to the embodiment of the present invention described above. Therefore, the detailed description regarding the composition and the like of each of the layers will not be repeated.

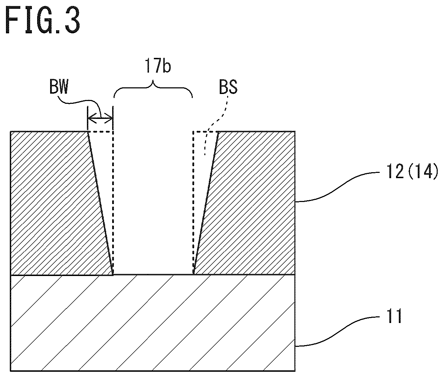

FIG. 3 is a schematic cross-sectional view illustrating the shape of the phase shift film 14 (phase layer 12) after electron beam modification etching when the phase shift film 14 is produced using only the single-layer phase layer 12. In the electron beam modification etching, for example, by irradiating a portion to be etched with an electron beam while supplying fluorine-based gas (gas including xenon and fluorine, for example, XeF₂) as etching gas, the reactivity of fluorine with an etchant is promoted, and the materials configuring the phase shift film 14 (phase layer 12) are etched. However, the material configuring the phase layer 12 has strong etching resistance to the above-described fluorine-based gas, and a very long period of time is required for the etching. Therefore, damage occurs toward a direction (in-plane direction of the phase layer 12) perpendicular to an etching direction (direction from the surface side of the phase layer 12 toward the substrate 11 side) called side etching BS illustrated in FIG. 3. When the side etching occurs, a line width of the portion etched by the electron beam modification etching is largely different from a predetermined line width, which is one cause for modification failure.

On a side surface of the phase layer 12 on which the phase shift film pattern 17 is formed, that is, a side surface adjacent to an electron beam modification etching portion 17b, when a portion that protrudes most in the in-plane direction of the phase layer 12 is set as a protrusion portion and when a portion that retracts most in the in-plane direction of the phase layer 12 is set as a recessed portion, "side etching amount (the width of side etching) BW" illustrated in FIG. 3 refers to a distance from the protrusion portion to the recessed portion in the in-plane direction of the phase layer 12. In FIG. 3, the above-described protrusion portion corresponds to a portion of the phase layer 12 adjacent to the substrate 11, and the above-described recessed portion corresponds to the surface portion of the phase layer 12. The side etching amount BW according to the embodiment of the present invention is preferably 5 nm or less. When the side etching amount BW is 5 nm or less, deterioration in transfer performance can be reduced.

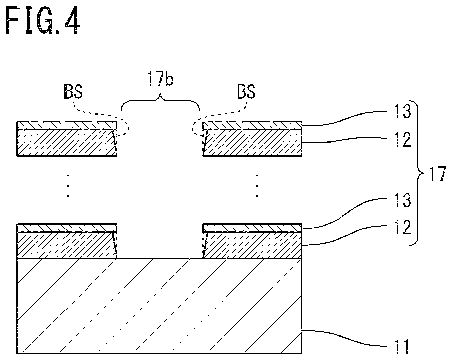

In the present embodiment, as illustrated in FIG. 4, by using the phase shift film 14 where the protective layers 13 where an electron beam modification etching rate is higher than the material configuring the phase layer 12 and the phase layers 12 where an electron beam modification etching rate is lower than the material configuring the protective layer 13 are alternately deposited, the side etching BS can be suppressed, and the success rate of electron beam modification etching can be improved.

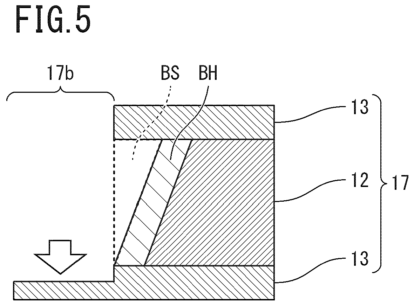

Hereinafter, the detailed mechanism will be described using FIG. 5 illustrating an enlarged part of the phase shift film 14.

FIG. 5 is a diagram illustrating a state in the middle of electron beam modification etching the protective layer 13 positioned inside the phase shift film 14, and BH represents a protective layer (etching-resistant film) formed on the side surface of the phase layer 12. When the phase shift film 14 according to the present embodiment is electron beam modification etched, a multi-stage etching process where the etching gas switches between etching gas for the protective layer 13 and etching gas for the phase layer 12 is preferably used. However, an etching process where the etching gas does not switch between etching gas for the protective layer 13 and etching gas for the phase layer 12 may also be used. When the phase layer 12 and the protective layer 13 are etched with one kind of etching gas, it is preferable to use fluorine-based gas (for example, XeF₂) for etching as described above. For the phase layer 12, the above-described fluorine-based gas (for example, XeF₂) has a weak function as the etching gas and functions as deposition gas. Therefore, the phase layer 12 is not likely to be etched with the fluorine-based gas, and the protective layer BH is formed on the side surface of the phase layer 12. Therefore, by using the phase shift film 14 that is a multi-layer phase shift film where the protective layers 13 and the phase layers 12 are deposited, as illustrated in FIG. 4, electron beam modification etching where the occurrence of the side etching BS is suppressed can be performed.

In the present embodiment, a modification etching rate during the electron beam modification of only the protective layer 13 may be in a range of 1 time or more and 10 times or less, is preferably in a range of 4 times or more and 8 times or less, and is more preferably in a range of 5 times or more and 7 times or less with respect to a modification etching rate during the electron beam modification of only the phase layer 12. When the modification etching rate during the electron beam modification of only the protective layer 13 is in the above-described numerical range, a period of time required for the electron beam modification can be effectively reduced compared to the related art.

In addition, in the present embodiment, the modification etching rate during the electron beam modification of only the phase layer 12 is, for example, preferably 2.5 nm/min or higher, more preferably 3.0 nm/min or higher, and still more preferably 3.5 nm/min or higher. When the modification etching rate during the electron beam modification of only the phase layer 12 is in the above-described numerical range, a period of time required for the electron beam modification can be effectively reduced compared to the related art.

The protective layer BH is, for example, a layer formed of at least one of an oxide film, a nitride film, an oxynitride film, and a carbide film that contain one or more compounds selected from tantalum metal, a tantalum compound, tungsten metal, a tungsten compound, tellurium metal, and a tellurium compound. That is, in the present embodiment, the protective layer BH that has a composition different from the composition of the phase layer 12 and covers at least a part of the side surface of the phase layer 12 where the phase shift film pattern 17 is formed to protect the side surface of the phase layer 12 may be further provided.

In the present embodiment, during the electron beam modification etching, the protective layer 13 may be surface-oxidized immediately before the electron beam modification etching of each of the protective layers 13 for each of the protective layers 13. That is, in the present embodiment, during the electron beam modification etching, first, a step of surface-oxidizing the protective layer 13, electron beam modification etching the surface-oxidized protective layer 13, electron beam modification etching the phase layer 12 positioned below the electron beam modification etched protective layer 13, and surface-oxidizing the protective layer 13 positioned below the electron beam modification etched phase layer 12 may be repeated.

### (Method for Manufacturing Phase Shift Mask)

A method for manufacturing the phase shift mask 100 using the phase shift mask blank 10 according to the present embodiment includes: a step of forming a light shielding film 15 on the phase shift film 14; a step of forming a resist pattern 16 on the light shielding film 15 formed on the phase shift film 14; a step of forming a pattern on the light shielding film 15 by oxygen-containing chlorine-based etching (Cl/O-based) after forming the resist pattern 16; a step of forming a pattern on the phase shift film 14 by fluorine-based etching (F-based) after forming the pattern on the light shielding film 15; a step of removing the resist pattern 16 after forming the pattern on the phase shift film 14; and a step of removing the light shielding film 15 by oxygen-containing chlorine-based etching (Cl/O-based) from the phase shift film 14 after removing the resist pattern 16.

Here, the light shielding film 15 according to the embodiment of the present invention will be described.

### <Light Shielding Film>

The light shielding film 15 is a layer formed on the phase shift mask blank 10 (protective layer 13) according to the embodiment of the present invention.

The light shielding film 15 is, for example, a single-layer film including a chromium simple substance or a chromium compound or is a multi-layer film or a graded film thereof. More specifically, the light shielding film 15 including the chromium compound is a single-layer film that contains chromium and one or more elements selected from nitrogen and oxygen or is a multi-layer film or a graded film thereof.

In the light shielding film 15 including the chromium compound, in an element ratio of the entire light shielding film 15, the content of chromium is preferably in a range of 30 at% or more and 100 at% or less, the content of oxygen is preferably in a range of 0 at% or more and 50 at% or less, the content of nitrogen is preferably in a range of 0 at% or more and 50 at% or less, and the content of carbon is preferably in a range of 0 at% or more and 10 at% or less. As a more preferable range of the content of each of the elements in the light shielding film 15 including the chromium compound, in the element ratio of the entire light shielding film 15, the content of chromium is preferably in a range of 50 at% or more and 100 at% or less, the content of oxygen is preferably in a range of 0 at% or more and 40 at% or less, the content of nitrogen is preferably in a range of 0 at% or more and 40 at% or less, and the content of carbon is preferably in a range of 0 at% or more and 5 at% or less. When the content of each of the elements in the light shielding film 15 including the chromium compound is in the above-described numerical range, the light shielding performance of the light shielding film 15 is improved.

A film thickness of the light shielding film 15 is, for example, in a range of 35 nm or more and 80 nm or less and particularly preferably in a range of 40 nm or more and 75 nm or less.

The light shielding film 15 can be formed using a well-known method. Preferable examples of a method for most easily obtaining a film having excellent homogeneity include a sputtering method. The present embodiment is not limited to the sputtering method.

A target and sputtering gas are selected depending on the film composition. For example, as a method for forming a film containing chromium, a method of performing reactive sputtering using a target containing chromium in only inert gas such as argon gas, in only reactive gas such as oxygen, or in mixed gas of inert gas and reactive gas can be performed. The flow rate of the sputtering gas may be adjusted depending on film characteristics, may be uniform during film forming, or when the oxygen content or the nitrogen content is desired to change in a film thickness direction, may change depending on a target composition. In addition, power applied to the target, a distance between the target and the substrate, or an internal pressure of a film forming chamber may be adjusted.

When the light shielding film 15 according to the present embodiment is the above-described multi-layer film, the film thicknesses of the layers may be different from each other or the same as each other. For example, when the light shielding film 15 has a two-layer structure including a lower light shielding film (not illustrated) formed on the phase shift mask blank 10 (protective layer 13) side and an upper light shielding film (not illustrated) formed on the lower light shielding film, the film thickness of the lower light shielding film may be more than or less than the film thickness of the upper light shielding film.

When the light shielding film 15 according to the present embodiment is a multi-layer film, film kinds (the kind of the constituent material or the composition ratio) of the layers may be different from each other or the same as each other.

Hereinafter, each of the steps in the method for manufacturing the phase shift mask 100 according to the embodiment of the present invention will be described.

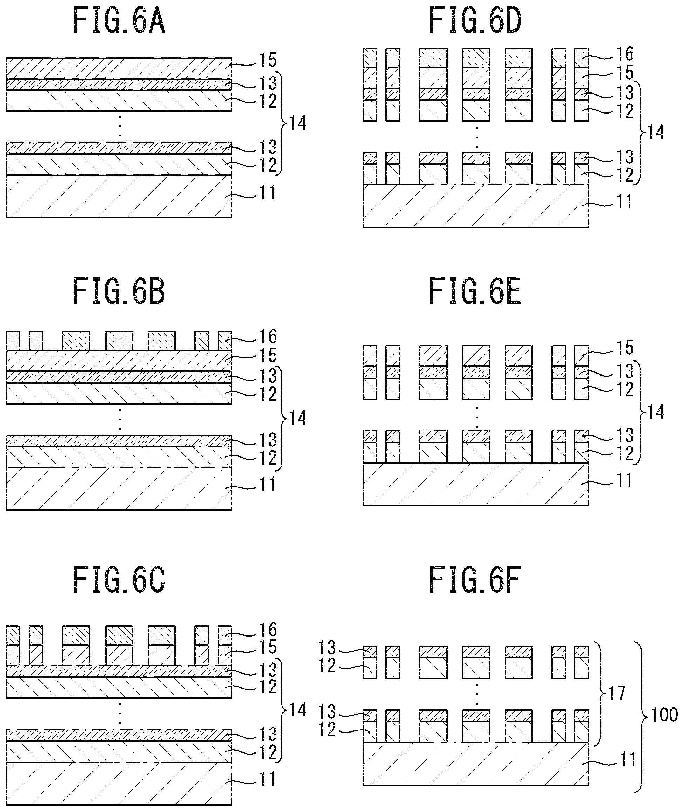

FIG. 6 is a schematic cross-sectional view illustrating steps of manufacturing the phase shift mask 100 using the phase shift mask blank 10 illustrated in FIG. 1. FIG. 6A illustrates a step of forming the light shielding film 15 on the phase shift film 14. FIG. 6B illustrates a step of forming the resist pattern 16 by applying a resist film to the light shielding film 15, drawing a pattern, and developing the pattern. FIG. 6C illustrates a step of patterning the light shielding film 15 along the resist pattern 16 by oxygen-containing chlorine-based dry etching (Cl/O-based). FIG. 6D illustrates a step of forming the phase shift film pattern 17 by patterning the phase shift film 14 along the pattern of the light shielding film 15 by fluorine-based etching (F-based). FIG. 6E illustrates a step of peeling and removing the resist pattern 16 and cleaning the mask. FIG. 6F illustrates a step of removing the light shielding film 15 by oxygen-containing chlorine-based etching (Cl/O-based) from the phase shift film 14 on which the phase shift film pattern 17 is formed. This way, the phase shift mask 100 according to the present embodiment is manufactured.

The phase shift mask 100 according to the present embodiment is a phase shift mask to which exposure light having a wavelength of 200 nm or less is applied, the phase shift mask including: the substrate 11; and the phase shift film 14 formed on the substrate 11 with or without another film interposed. In addition, the phase shift film 14 is a multi-layer phase shift film in which a plurality of phase layers 12 that are capable of adjusting a predetermined amount of each of a phase and a transmittance to with respect to exposure light to be transmitted and a plurality of protective layers 13 configured to prevent gas permeation to the phase layers 12 are alternately deposited, the protective layer 13 being formed on the phase layer 12. In addition, a modification etching rate during electron beam modification of the protective layer 13 is higher than a modification etching rate of the phase layer 12. In addition, the phase shift mask 100 includes a phase shift film pattern 17 formed by removing a part of the phase shift film 14 to expose a part of the substrate 11.

In the step of FIG. 6B, as a material of the resist film, a positive resist or a negative resist can also be used. However, a chemically amplified resist for electron beam drawing capable of forming a high accuracy pattern is preferably used. A film thickness of the resist film is, for example, in a range of 50 nm or more and 250 nm or less. In particular, when a phase shift mask required for forming a fine pattern is produced, the film thickness of the resist film needs to be small and is preferably 200 nm or less such that an aspect ratio of the resist pattern 16 does not increase to prevent pattern collapse. On the other hand, the lower limit of the film thickness of the resist film is determined in comprehensive consideration of conditions such as the etching resistance of the resist material to be used and is preferably 60 nm or more. When a chemically amplified resist for electron beam drawing is used as a resist film, an energy density of an electron beam during drawing is in a range of 35 µC/cm² to 100 µC/cm², and by performing a heat treatment and a development treatment after the drawing, the resist pattern 16 is obtained.

In addition, in the step of FIG. 6E, the peeling and removal of the resist pattern 16 may be wet peeling using a peeling solution or may be dry peeling by dry etching.

In addition, in the step of FIG. 6C, as conditions of the oxygen-containing chlorine-based dry etching (Cl/O-based) for patterning the light shielding film 15 including a chromium simple substance or a chromium compound, well-known conditions that have been used for removing the chromium compound film may be used, and the chlorine gas and the oxygen gas may be optionally mixed with inert gas such as nitrogen gas or helium gas. The phase shift film 14 positioned below the light shielding film 15 has resistance to the oxygen-containing chlorine-based dry etching (Cl/O-based) and thus remains without being removed or patterned in the present step.

In addition, in the step of FIG. 6D, as conditions of the fluorine-based dry etching (F-based) for patterning the phase shift film 14, well-known conditions that have been used for dry etching a silicon-based compound film, a tantalum compound film, a molybdenum compound film, or the like may be used, CF₄, C₂F₆, or SF₆ is generally used as the fluorine-based gas, and the fluorine-based gas may be optionally mixed with active gas such as oxygen or inert gas such as nitrogen gas or helium gas. In FIG. 6D, the light shielding film 15 or the resist pattern 16 positioned above the phase shift film 14 has resistance to the fluorine-based dry etching (F-based) and thus remains without being removed or patterned in the present step. In FIG. 6D, concurrently, the substrate 11 is dug by about 1 nm to 3 nm to prevent the removal defect of the phase shift film 14, and the phase difference is finely adjusted in general.

In addition, in the step of FIG. 6F, as conditions of the oxygen-containing chlorine-based dry etching (Cl/O-based) for removing the light shielding film 15, well-known conditions that have been used for removing the chromium compound film may be used, and the chlorine gas and the oxygen gas may be optionally mixed with inert gas such as nitrogen gas or helium gas. Both of the phase shift film 14 and the substrate 11 positioned below the light shielding film 15 have resistance to the oxygen-containing chlorine-based dry etching (Cl/O-based) and thus remain without being removed or patterned in the present step.

### (Modification Example)

In the present embodiment, regarding the shape of the surface of the phase layer 12 on which the side etching BS is performed, that is, the side-etched surface, the configuration where the side-etched surface is inclined at a given ratio from the surface side of the phase layer 12 toward the substrate 11 side is described using FIGS. 3 to 5. However, the present invention is not limited to this configuration.

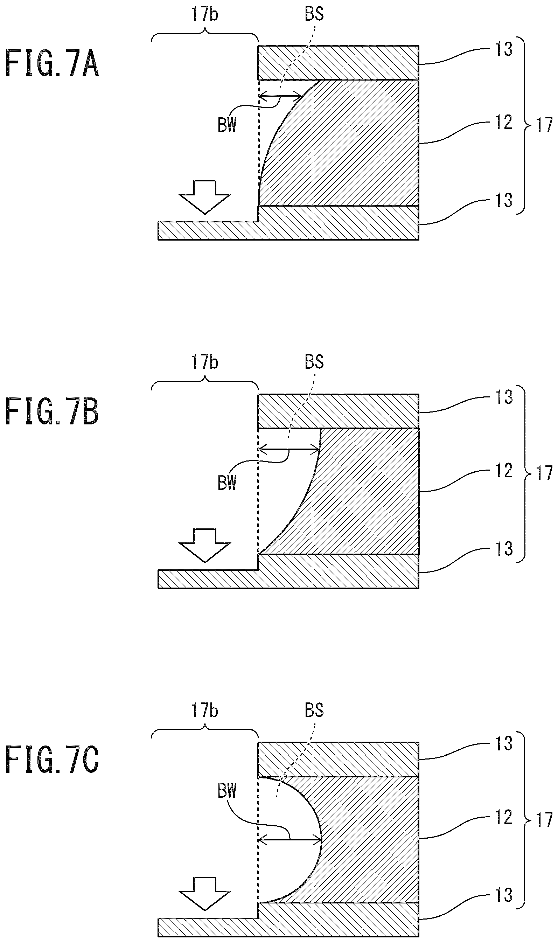

As illustrated in FIGS. 7A to 7C, for example, a configuration where the shape of the side-etched surface is curved may be adopted. In addition, for example, the side etching amount (the width of the side etching BS) BW may be the largest on the upper surface side of the phase layer 12 as illustrated in FIGS. 7A and 7B, or may be the largest in the center portion of the phase layer 12 as illustrated in FIG. 7C. FIGS. 7A to 7C do not illustrate the protective layer BH.

### [Examples]

Hereinafter, the embodiments of the present invention will be described in more detail using Examples. However, the present invention is not limited to the following examples but rather defined by the appended claims .

### (Example 1)

Using a DC sputtering apparatus using two targets, a phase layer including silicon, molybdenum, oxygen, and nitrogen having a thickness of 14 nm was formed on a quartz substrate. Molybdenum and silicon were used as the targets, and argon, oxygen, and nitrogen were used as the sputtering gas. When the composition of the phase layer was analyzed by ESCA, the composition was Si:Mo:O:N = 42:7:5:46 (at% ratio).

Using the DC sputtering apparatus, a protective layer including tantalum and oxygen having a thickness of 2 nm was formed on the phase layer. Tantalum was used as the target, and argon and oxygen were used as the sputtering gas. When the composition of the protective layer was analyzed by ESCA, the composition was Ta:O = 35:65 (at% ratio).

Five pairs of multi-layer films including the phase layers and the protective layers formed as described above were deposited, that is, five phase layers having a film thickness of 14 nm and five protective layers having a film thickness of 2 nm were alternately deposited to form, as a phase shift film (multi-layer phase shift film), a multi-layer deposited film where a total film thickness of the phase layers was 70 nm, a total film thickness of the protective layers was 10 nm, and a total thickness (film thickness) of the phase layers and the protective layers was 80 nm. In addition, in the phase shift film, a transmittance of exposure light was 5%, and a phase difference was 177 degrees.

Next, using the DC sputtering apparatus, a lower light shielding film including chromium, oxygen, and nitrogen having a thickness of 30 nm was formed on the protective layer positioned on the outermost layer (uppermost layer) of the phase shift film. Chromium was used as the target, and argon, oxygen, and nitrogen were used as the sputtering gas. When the composition of the lower light shielding film was analyzed by ESCA, the composition was Cr:O:N = 50:30:20 (at% ratio).

Next, using the DC sputtering apparatus, an upper light shielding film including chromium, oxygen, and nitrogen having a thickness of 20 nm was formed on the lower light shielding film. Chromium was used as the target, and argon, oxygen, and nitrogen were used as the sputtering gas. When the composition of the upper light shielding film was analyzed by ESCA, the composition was Cr:O:N = 45:45:10 (at% ratio).

An Optical Density (OD) value of the phase shift mask blank according to Example 1 formed as described above was 3.

Next, a negative chemically amplified electron beam resist having a film thickness of 160 nm was spin-coated on the upper light shielding film, and a pattern was drawn with an electron beam at a dosage of 35 µC/cm², was heated at 110°C for 10 minutes, and was developed by puddle development for 90 seconds to form a resist pattern.

Next, using a dry etching apparatus, each of the upper light shielding film and the lower light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film where five protective layers and five phase layers were alternately deposited was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, each of the light shielding films was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film (lower light shielding film) was not damaged.

This way, a phase shift mask according to Example 1 was obtained.

Next, regarding the phase shift mask, a dosage at which the haze was formed by accelerated exposure was measured and was 110 kJ/cm².

Regarding "the dosage at which the haze was formed by accelerated exposure, as the value increases, the haze is not likely to be formed. It can be said that, when the dosage is 70 kJ/cm² or more (in the following table, evaluated as "Δ"), there are no problems in using the phase shift mask, when the dosage is 80 kJ/cm² or more (in the following table, evaluated as "o"), the phase shift mask is excellent to use, and when the dosage is 100 kJ/cm² or more (in the following table, evaluated as "⊚"), the haze is not likely to be formed in the phase shift mask. It can be said that, when the dosage is less than 70 kJ/cm² (in the following table, evaluated as "X"), the formation of haze cannot be ignored in using the phase shift mask.

It was verified from the above-described measurement result, in the phase shift mask according to Example 1, the dosage is 110 kJ/cm², and thus the formation of haze can be reduced.

Next, electron beam modification was performed on the phase shift mask. Hereinafter, a method of the electron beam modification will be described.

### (Correction Method)

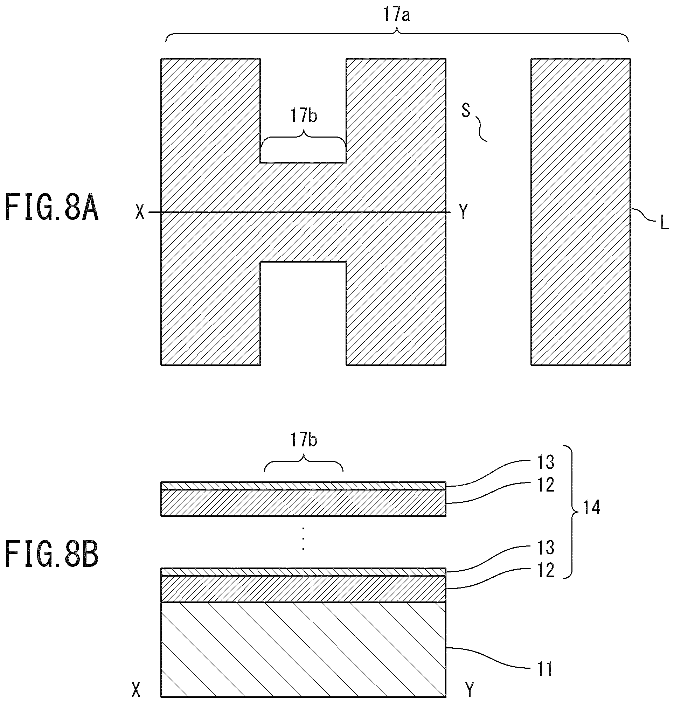

Next, the method of the electron beam modification of the phase shift mask 100 will be described using FIGS. 8 to 11.

FIG. 8 is a diagram illustrating an enlarged part of the phase shift film 14 in the phase shift mask 100. More specifically, FIG. 8A is a schematic plan view illustrating a structure before the modification step of the phase shift mask 100 according to the present example, and FIG. 8B is a schematic cross-sectional view illustrating the structure before the modification step of the phase shift mask 100 according to the present example.

Hereinafter, when electron beam modification etching was performed on the formed phase shift film pattern 17 (17a) by performing dry etching using the resist pattern 16, a specific method will be described. In FIG. 8A, "L" represents a region where the phase shift film 14 was formed, and "S" represents a region where the transparent substrate 11 was exposed.

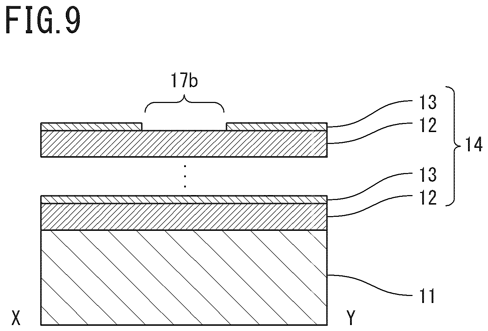

First, as illustrated in FIG. 9, the protective layer 13 as the outermost layer was irradiated with an electron beam using an electron beam corrector (MeRiT MG45: manufactured by Carl Zeiss Co., Ltd.) in fluorine-based gas, for example, a gas atmosphere (XeF₂) including fluorine and xenon for electron beam modification etching. At this time, a cold trap technology of controlling the fluorine-based gas flow rate based on the temperature was used. In the present example, the temperature of the fluorine-based gas was set to 0°C (hereinafter, referred to as the controlled temperature). In addition, the EB current was set to 50 pA, and the EB acceleration voltage was set to 1 kV.

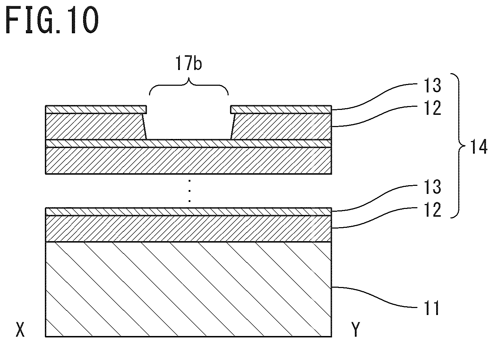

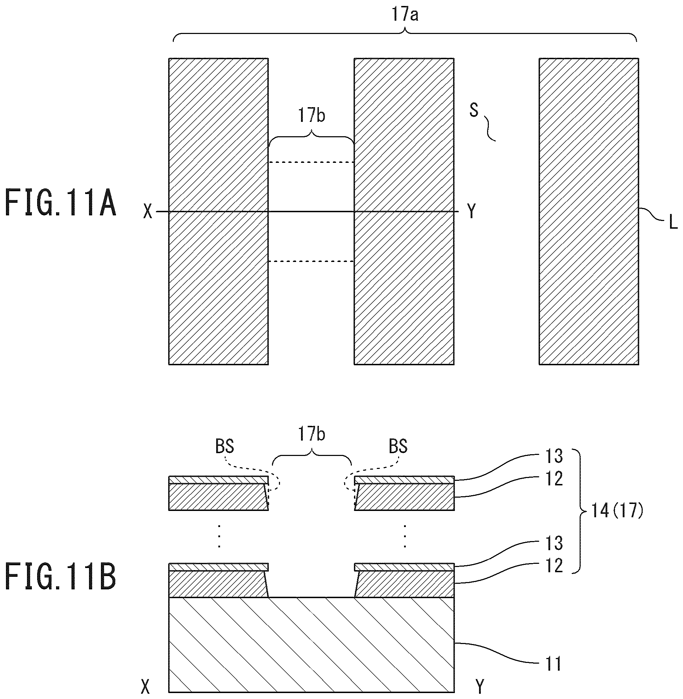

Next, as illustrated in FIG. 10, the phase layer 12 corresponding to the second layer from the outermost layer was irradiated with an electron beam in the fluorine-based gas atmosphere using the same device at the controlled temperature of 0°C as in the electron beam modification etching of the protective layer 13 as the uppermost layer for electron beam modification etching. By repeating the above-described steps, as illustrated in FIG. 11, the phase shift mask 100 where the entire phase shift film 14 was electron beam modification etched was obtained. At this time, it was verified that the amount of the side etching BS (side etching amount BW) was less than 1 nm by measuring the line width using a SEM (LWM9045: manufactured by ADVANTEST CORPORATION).

In addition, it was verified that a Qz etching selection ratio during the electron beam modification etching was 1.7. Here, "Qz etching selection ratio" represents a ratio between a modification etching rate of the protective layers and the phase layers (modification etching rate with respect to the entire phase shift film 14) and a modification etching rate of quartz (Qz) as the substrate. In addition, in Example 1, the selection ratio between the protective layer 13 and the phase layer 14 was 5.4.

For reference, each of the modification etching rates of the protective layer and the phase layer, and the etching rate ratio of the protective layer to the phase layer (the modification etching rate of the protective layer/the modification etching rate of the phase layer) were shown in each of the tables. When the etching rate ratio of the protective layer to the phase layer is 1 or more, the modification etching rate during the electron beam modification of the protective layer is higher than the modification etching rate during the electron beam modification of the phase layer.

Regarding "the amount of side etching BS (side etching amount BW)", as the value decreases, the transfer performance increases. It can be said that, when the side etching amount BW is 5 nm or less (in the following table, evaluated as "∘"), the transfer performance of the phase shift mask is sufficient, and when the side etching amount BW is 1 nm or less (in the following table, evaluated as "⊚"), the transfer performance of the phase shift mask is very high. It can be said that, when the side etching amount BW is more than 5 nm (in the following table, evaluated as "Δ"), a sufficient transfer performance for using the phase shift mask cannot be obtained.

It was verified from the measurement result that, in the phase shift mask according to Example 1, the side etching amount BW is 1 nm, and thus excellent transfer performance is obtained.

Regarding "the Qz etching selection ratio", as the value increases, the electron beam modification etching of the phase shift film becomes easier. It can be said that, when the Qz etching selection ratio is 1.2 or more (in the following table, evaluated as "o"), the electron beam modification of the phase shift film 14 is easy, and when the Qz etching selection ratio is 1.5 or more (in the following table, evaluated as "⊚"), the electron beam modification of the phase shift mask (phase shift film) is very easy. When the Qz etching selection ratio is less than 1.2 (in the following table, evaluated as "Δ"), the electron beam modification of the phase shift mask (phase shift film) is difficult to perform.

It was verified from the measurement result that, in the phase shift mask according to Example 1, the Qz etching selection ratio is 1.7, and thus the electron beam modification of the phase shift mask (phase shift film) is very easy.

### (Example 2)

Using a DC sputtering apparatus using two targets, a phase layer including silicon, molybdenum, oxygen, and nitrogen having a thickness of 15 nm was formed on a quartz substrate. Molybdenum and silicon were used as the targets, and argon, oxygen, and nitrogen were used as the sputtering gas. When the composition of the phase layer was analyzed by ESCA, the composition was Si:Mo:O:N = 42:7:5:46 (at% ratio).

Using the DC sputtering apparatus, a protective layer including tantalum and nitrogen having a thickness of 2 nm was formed on the phase layer. Tantalum was used as the target, and argon and nitrogen were used as the sputtering gas. When the composition of the protective layer was analyzed by ESCA, the composition was Ta:N = 80:20 (at% ratio).

Five pairs of multi-layer films including the phase layers and the protective layers formed as described above were deposited, that is, five phase layers having a film thickness of 15 nm and five protective layers having a film thickness of 2 nm were alternately deposited to form, as a phase shift film (multi-layer phase shift film), a multi-layer deposited film where a total film thickness of the phase layers was 75 nm, a total film thickness of the protective layers was 10 nm, and a total thickness (film thickness) of the phase layers and the protective layers was 85 nm. In addition, in the phase shift film, a transmittance of exposure light was 5%, and a phase difference was 177 degrees.

Next, using the DC sputtering apparatus, a lower light shielding film including chromium, oxygen, and nitrogen having a thickness of 30 nm was formed on the protective layer positioned on the outermost layer (uppermost layer) of the phase shift film. Chromium was used as the target, and argon, oxygen, and nitrogen were used as the sputtering gas. When the composition of the lower light shielding film was analyzed by ESCA, the composition was Cr:O:N = 50:30:20 (at% ratio).

Next, using the DC sputtering apparatus, an upper light shielding film including chromium, oxygen, and nitrogen having a thickness of 20 nm was formed on the lower light shielding film. Chromium was used as the target, and argon, oxygen, and nitrogen were used as the sputtering gas. When the composition of the upper light shielding film was analyzed by ESCA, the composition was Cr:O:N = 45:45:10 (at% ratio).

An Optical Density (OD) value of the phase shift mask blank according to Example 2 formed as described above was 3.

Next, a negative chemically amplified electron beam resist having a film thickness of 160 nm was spin-coated on the upper light shielding film, and a pattern was drawn with an electron beam at a dosage of 35 µC/cm², was heated at 110°C for 10 minutes, and was developed by puddle development for 90 seconds to form a resist pattern.

Next, using a dry etching apparatus, each of the upper light shielding film and the lower light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film where five protective layers and five phase layers were alternately deposited was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, each of the light shielding films was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film (lower light shielding film) was not damaged.

This way, a phase shift mask according to Example 2 was obtained.

Next, regarding the phase shift mask, a dosage at which the haze was formed by accelerated exposure was measured and was 90 kJ/cm².

It was verified from the above-described result, in the phase shift mask according to Example 2, the dosage is 90 kJ/cm², and thus the formation of haze can be reduced.

Next, electron beam modification was performed on the phase shift mask, and the side etching amount BW was measured and was 2 nm.

It was verified from the above-described result that, in the phase shift mask according to Example 2, the side etching amount BW is 2 nm, and thus sufficient transfer performance is obtained.

Next, the Qz etching selection ratio during the electron beam modification of the phase shift mask was measured and was 1.9.

It was verified from the above-described result that, in the phase shift mask according to Example 2, the Qz etching selection ratio is 1.9, and thus the electron beam modification of the phase shift mask (phase shift film) is very easy.

In addition, in Example 2, the selection ratio between the protective layer 13 and the phase layer 14 was 5.7.

### (Example 3)

Using a DC sputtering apparatus using two targets, a phase layer including silicon, molybdenum, oxygen, and nitrogen having a thickness of 16 nm was formed on a quartz substrate. Molybdenum and silicon were used as the targets, and argon, oxygen, and nitrogen were used as the sputtering gas. When the composition of the phase layer was analyzed by ESCA, the composition was Si:Mo:O:N = 42:7:5:46 (at% ratio).

Using the DC sputtering apparatus, a protective layer including tungsten and oxygen having a thickness of 2 nm was formed on the phase layer. Tungsten was used as the target, and argon and oxygen were used as the sputtering gas. When the composition of the protective layer was analyzed by ESCA, the composition was W:O = 25:75 (at% ratio).

Five pairs of multi-layer films including the phase layers and the protective layers formed as described above were deposited, that is, five phase layers having a film thickness of 16 nm and five protective layers having a film thickness of 2 nm were alternately deposited to form, as a phase shift film (multi-layer phase shift film), a multi-layer deposited film where a total film thickness of the phase layers was 80 nm, a total film thickness of the protective layers was 10 nm, and a total thickness (film thickness) of the phase layers and the protective layers was 90 nm. In addition, in the phase shift film, a transmittance of exposure light was 5%, and a phase difference was 177 degrees.

Next, using the DC sputtering apparatus, a lower light shielding film including chromium, oxygen, and nitrogen having a thickness of 30 nm was formed on the protective layer positioned on the outermost layer (uppermost layer) of the phase shift film. Chromium was used as the target, and argon, oxygen, and nitrogen were used as the sputtering gas. When the composition of the lower light shielding film was analyzed by ESCA, the composition was Cr:O:N = 50:30:20 (at% ratio).

Next, using the DC sputtering apparatus, an upper light shielding film including chromium, oxygen, and nitrogen having a thickness of 20 nm was formed on the lower light shielding film. Chromium was used as the target, and argon, oxygen, and nitrogen were used as the sputtering gas. When the composition of the upper light shielding film was analyzed by ESCA, the composition was Cr:O:N = 45:45:10 (at% ratio).

An Optical Density (OD) value of the phase shift mask blank according to Example 3 formed as described above was 3.

Next, a negative chemically amplified electron beam resist having a film thickness of 160 nm was spin-coated on the upper light shielding film, and a pattern was drawn with an electron beam at a dosage of 35 µC/cm², was heated at 110°C for 10 minutes, and was developed by puddle development for 90 seconds to form a resist pattern.

Next, using a dry etching apparatus, each of the upper light shielding film and the lower light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film where five protective layers and five phase layers were alternately deposited was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, each of the light shielding films was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film (lower light shielding film) was not damaged.

This way, a phase shift mask according to Example 3 was obtained.

Next, regarding the phase shift mask, a dosage at which the haze was formed by accelerated exposure was measured and was 75 kJ/cm².

It was verified from the above-described result, in the phase shift mask according to Example 3, the dosage is 75 kJ/cm², and thus the formation of haze can be reduced.

Next, electron beam modification was performed on the phase shift mask, and the side etching amount BW was measured and was 3 nm.

It was verified from the above-described result that, in the phase shift mask according to Example 3, the side etching amount BW is 3 nm, and thus sufficient transfer performance is obtained.

Next, the Qz etching selection ratio during the electron beam modification of the phase shift mask was measured and was 1.4.

It was verified from the above-described result that, in the phase shift mask according to Example 3, the Qz etching selection ratio is 1.4, and thus the electron beam modification of the phase shift mask (phase shift film) is very easy.

In addition, in Example 3, the selection ratio between the protective layer 13 and the phase layer 14 was 4.0.

### (Example 4)

Using a DC sputtering apparatus using two targets, a phase layer including silicon, molybdenum, oxygen, and nitrogen having a thickness of 15 nm was formed on a quartz substrate. Molybdenum and silicon were used as the targets, and argon, oxygen, and nitrogen were used as the sputtering gas. When the composition of the phase layer was analyzed by ESCA, the composition was Si:Mo:O:N = 42:7:5:46 (at% ratio).

Using the DC sputtering apparatus, a protective layer including tellurium and oxygen having a thickness of 2 nm was formed on the phase layer. Tellurium was used as the target, and argon and oxygen were used as the sputtering gas. When the composition of the protective layer was analyzed by ESCA, the composition was Te:O = 35:65 (at% ratio).

Five pairs of multi-layer films including the phase layers and the protective layers formed as described above were deposited, that is, five phase layers having a film thickness of 15 nm and five protective layers having a film thickness of 2 nm were alternately deposited to form, as a phase shift film (multi-layer phase shift film), a multi-layer deposited film where a total film thickness of the phase layers was 75 nm, a total film thickness of the protective layers was 10 nm, and a total thickness (film thickness) of the phase layers and the protective layers was 85 nm. In addition, in the phase shift film, a transmittance of exposure light was 5%, and a phase difference was 177 degrees.

Next, using the DC sputtering apparatus, a lower light shielding film including chromium, oxygen, and nitrogen having a thickness of 30 nm was formed on the protective layer positioned on the outermost layer (uppermost layer) of the phase shift film. Chromium was used as the target, and argon, oxygen, and nitrogen were used as the sputtering gas. When the composition of the lower light shielding film was analyzed by ESCA, the composition was Cr:O:N = 50:30:20 (at% ratio).

Next, using the DC sputtering apparatus, an upper light shielding film including chromium, oxygen, and nitrogen having a thickness of 20 nm was formed on the lower light shielding film. Chromium was used as the target, and argon, oxygen, and nitrogen were used as the sputtering gas. When the composition of the upper light shielding film was analyzed by ESCA, the composition was Cr:O:N = 45:45:10 (at% ratio).

An Optical Density (OD) value of the phase shift mask blank according to Example 4 formed as described above was 3.

Next, a negative chemically amplified electron beam resist having a film thickness of 160 nm was spin-coated on the upper light shielding film, and a pattern was drawn with an electron beam at a dosage of 35 µC/cm², was heated at 110°C for 10 minutes, and was developed by puddle development for 90 seconds to form a resist pattern.

Next, using a dry etching apparatus, each of the upper light shielding film and the lower light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film where five protective layers and five phase layers were alternately deposited was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, each of the light shielding films was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film (lower light shielding film) was not damaged.

This way, a phase shift mask according to Example 4 was obtained.

Next, regarding the phase shift mask, a dosage at which the haze was formed by accelerated exposure was measured and was 71 kJ/cm².

It was verified from the above-described result, in the phase shift mask according to Example 4, the dosage is 71 kJ/cm², and thus the formation of haze can be reduced.

Next, electron beam modification was performed on the phase shift mask, and the side etching amount BW was measured and was 2 nm.

It was verified from the above-described result that, in the phase shift mask according to Example 4, the side etching amount BW is 2 nm, and thus sufficient transfer performance is obtained.

Next, the Qz etching selection ratio during the electron beam modification of the phase shift mask was measured and was 1.3.

It was verified from the above-described result that, in the phase shift mask according to Example 4, the Qz etching selection ratio is 1.3, and thus the electron beam modification of the phase shift mask (phase shift film) is very easy.

In addition, in Example 4, the selection ratio between the protective layer 13 and the phase layer 14 was 2.6.

### (Comparative Example 1)

Using a DC sputtering apparatus using two targets, a phase layer including silicon, molybdenum, oxygen, and nitrogen having a thickness of 75 nm was formed on a quartz substrate. Molybdenum and silicon were used as the targets, and argon, oxygen, and nitrogen were used as the sputtering gas. When the composition of the phase layer was analyzed by ESCA, the composition was Si:Mo:O:N = 42:7:5:46 (at% ratio).

Next, using the DC sputtering apparatus, a lower light shielding film including chromium, oxygen, and nitrogen having a thickness of 30 nm was formed on the phase layer. Chromium was used as the target, and argon, oxygen, and nitrogen were used as the sputtering gas. When the composition of the light shielding film was analyzed by ESCA, the composition was Cr:O:N = 50:30:20 (at% ratio).

Next, using the DC sputtering apparatus, an upper light shielding film including chromium, oxygen, and nitrogen having a thickness of 20 nm was formed on the lower light shielding film. Chromium was used as the target, and argon, oxygen, and nitrogen were used as the sputtering gas. When the composition of the upper light shielding film was analyzed by ESCA, the composition was Cr:O:N = 45:45:10 (at% ratio).

An Optical Density (OD) value of the phase shift mask blank according to Comparative Example 1 formed as described above was 3.

Next, a negative chemically amplified electron beam resist having a film thickness of 160 nm was spin-coated on the upper light shielding film, and a pattern was drawn with an electron beam at a dosage of 35 µC/cm², was heated at 110°C for 10 minutes, and was developed by puddle development for 90 seconds to form a resist pattern.

Next, using a dry etching apparatus, each of the upper light shielding film and the lower light shielding film was patterned. Chlorine, oxygen, and helium were used as the etching gas, the gas pressure was set to 5 mTorr, the ICP power was set to 400 W, and the bias power was set to 40 W. Overetching was performed by 100%.

Next, using the dry etching apparatus, the phase shift film including only the phase layer was patterned. CF₄ and oxygen were used as the etching gas, the gas pressure was set to 5 mTorr, the ICP power was set to 400 W, and the bias power was set to 40 W. When the quartz substrate was dug by 3 nm on average, the dry etching was stopped.

Next, the resist pattern was peeled and cleaned by sulfuric acid-hydrogen peroxide mixture cleaning.

Next, using the dry etching apparatus, each of the light shielding films was removed. Chlorine, oxygen, and helium were used as the etching gas, the gas pressure was set to 10 mTorr, the ICP power was set to 500 W, and the bias power was set to 10 W. Overetching was performed by 200%. At this time, the phase shift film and the quartz substrate positioned below the light shielding film (lower light shielding film) was not damaged.

This way, a phase shift mask according to Comparative Example 1 was obtained. That is, the phase shift mask according to Comparative Example 1 was a phase shift mask not including the protective layers formed in Examples 1 to 4 and not including the multi-layer phase shift film where five protective layers and five phase layers formed in Examples 1 to 4 were alternately deposited.

Next, regarding the phase shift mask, a dosage at which the haze was formed by accelerated exposure was measured and was 58 kJ/cm².

It was verified from the above-described result, in the phase shift mask according to Comparative Example 1, the dosage is 58 kJ/cm², and thus the formation of haze cannot be sufficiently reduced.

Next, electron beam modification was performed on the phase shift mask, and the side etching amount BW was measured and was 7 nm.

It was verified from the above-described result that, in the phase shift mask according to Comparative Example 1, the side etching amount BW is 7 nm, and thus sufficient transfer performance is not obtained.

Next, the Qz etching selection ratio during the electron beam modification of the phase shift mask was measured and was 1.1.

It was verified from the above-described result that, in the phase shift mask according to Comparative Example 1, the Qz etching selection ratio is 1.1, and thus the electron beam modification of the phase shift mask (phase shift film) is difficult.

The evaluation results of Examples 1 to 4 and Comparative Example 1 are shown in Tables 1 and 2. In the present example, each of the haze resistance (the dosage at which the haze was formed), the modification processability (Qz etching selection ratio), the cross-sectional shape (side etching amount), and the transfer performance was evaluated.

Regarding the dosage at which the haze was formed, when the value is "70kJ/cm²" or more, there is no problem in use, which is evaluated as "Pass".

Regarding the side etching amount, when the value is "5 nm" or less, there is no problem in use, which is evaluated as "Pass".

Regarding the modification etching rate ratio, when the value is "1.2" or more, there is no problem in use, which is evaluated as "Pass".

In Tables 1 and 2, regarding the transfer performance, a case where there is no shadowing effect and there is no problem in transfer performance in use is evaluated as "∘", and a case where the shadowing effect is not ignorable and improvement of the transfer performance is required in use is evaluated as "△".

"Etching Time (min.) of Phase Shift Film (Protective Layer and Phase Layer)" in Table 1 refers to a value calculated using each of the Qz etching selection ratios assuming that "Etching Time (min.) of Phase Shift Film (Phase Layer)" in Table 2 was 30 (min.).

**[Table 1]**

| | | Ex. 1 | | Ex. 2 | | Ex. 3 | | Ex. 4 | |
|---|---|---|---|---|---|---|---|---|---|
| Layer | | Phase Layer | Protective Layer | Phase Layer | Protective Layer | Phase Layer | Protective Layer | Phase Layer | Protective Layer |
| Composition | | MoSix | TaOx | MoSix | TaNx | MoSix | WOx | MoSix | TeOx |
| Number of Deposition | | 5 | 5 | 5 | 5 | 5 | 5 | 5 | 5 |
| Each of Film Thicknesses (nm) and Total Film Thickness (nm) of Protective Layers | | - | 2(10) | - | 2(10) | - | 2(10) | - | 2(10) |
| Each of Film Thicknesses (nm) and Total Film Thickness (nm) of Phase Layers | | 14(70) | - | 15(75) | - | 16(80) | - | 15(75) | - |
| Haze Resistance | Dosage (kJ/cm²) | 110 | | 90 | | 75 | | 71 | |
| | Evaluation | ⊚ | | ○ | | Δ | | Δ | |
| Correction Processability | Etching Time of Phase Shift Film (Protective Layer and Phase Layer) (min.) | 19.4 | | 17.4 | | 23.6 | | 25.4 | |
| | Etching Rate of Protective Layer (nm/min.) | 20 | | 25 | | 14 | | 8 | |
| | Etching Rate of Phase Layer (nm/min.) | 3.7 | | 4.4 | | 3.5 | | 3.1 | |
| | Etching Rate Ratio of Protective Layer to Phase Layer (Protective Layer/Phase Layer) | 5.4 | | 5.7 | | 4.0 | | 2.6 | |
| | Qz Etching Selection Ratio | 1.7 | | 1.9 | | 1.4 | | 1.3 | |
| | Evaluation | ⊚ | | ⊚ | | ○ | | ○ | |
| Cross-Sectional Shape | Side Etching Amount (nm) | 1 | | 2 | | 3 | | 2 | |
| | Evaluation | ⊚ | | ○ | | ○ | | ○ | |
| Transfer Performance | Evaluation | ○ | | ○ | | ○ | | ○ | |

**[Table 2]**

| | | Comp. Ex. 1 | |
|---|---|---|---|
| Layer | | Phase Layer | Protective Layer |
| Composition | | MoSix | - |
| Number of Deposition | | 1 | - |
| Film Thickness of Protective Layer (nm) | | - | - |
| Film Thickness of Phase Layer (nm) | | 75 | - |
| Haze Resistance | Dosage (kJ/cm²) | 58 | |
| | Evaluation | × | |
| Correction Processability | Etching Time of Phase Shift Film (Phase Layer) (min.) | 30 | |
| | Etching Rate of Protective Layer (nm/min.) | - | |
| | Etching Rate of Phase Layer (nm/min.) | 2.5 | |
| | Etching Rate Ratio of Protective Layer to Phase Layer (Protective Layer/Phase Layer) | - | |
| | Qz Etching Selection Ratio | 1.1 | |
| | Evaluation | Δ | |
| Cross-Sectional Shape | Side Etching Amount (nm) | 7 | |
| | Evaluation | Δ | |
| Transfer Performance | Evaluation | Δ | |

As described above, it was found that the formation of the multi-layer phase shift film where the protective layer is formed on the phase layer and a plurality of phase layers and a plurality of protective layers are alternately deposited is effective for reducing the amount of formation of haze in the phase shift mask.

In addition, it was found that the formation of the multi-layer phase shift film where the protective layer is formed on the phase layer and a plurality of phase layers and a plurality of protective layers are alternately deposited is effective for facilitating the electron beam modification in the phase shift mask (phase shift film).

Further, it was found that the formation of the multi-layer phase shift film where the protective layer is formed on the phase layer and a plurality of phase layers and a plurality of protective layers are alternately deposited is effective for improving the transfer performance of the phase shift mask (phase shift film).

Hereinabove, the above-described embodiment describes the phase shift mask blank and the phase shift mask produced using the same of the present invention with reference to Examples, but Examples above are merely examples for implementing the present invention, and the present invention is not limited thereto but rather defined by the appended claims.

### Industrial Applicability

In the present invention, the composition, the film thickness, and the layer structure of the phase shift mask blank and the manufacturing steps and the conditions of the phase shift mask formed using the phase shift mask blank are selected in the appropriate ranges. Therefore, the phase shift mask where a fine pattern corresponding to the manufacturing of a logic device of 28 nm or less or a memory device of 30 nm or less is formed with high accuracy can be provided.

### Reference Signs List

- 10: phase shift mask blank
- 11: substrate that is transparent with respect to exposure wavelength (substrate)
- 12: phase layer (phase difference and transmittance adjustment layer)
- 13: protective layer (protective layer against gas permeation)
- 14: phase shift film (multi-layer phase shift film)
- 15: light shielding film
- 16: resist pattern
- 17: phase shift film pattern
- 17a: phase shift film pattern
- 17b: electron beam modification etching portion
- 100: phase shift mask
- BS: side etching
- BH: protective layer (etching-resistant film)
- BW: side etching amount (width of side etching)
- L: region where phase shift film is formed
- S: region where transparent substrate is exposed

## Claims

1. A phase shift mask blank (10) used for producing a phase shift mask (100) to which exposure light having a wavelength of 200 nm or less is applied, the phase shift mask blank (10) comprising:
a transparent substrate (11);
a phase shift film (14) formed on the transparent substrate (11); and
a light shielding film (15) formed on the phase shift film (14),
wherein the phase shift film (14) is a multi-layer phase shift film in which a plurality of phase difference and transmittance adjustment layers (12) that are capable of adjusting a predetermined amount of each of a phase and a transmittance with respect to exposure light to be transmitted and a plurality of protective layers (13) against gas permeation configured to prevent gas permeation to the phase difference and transmittance adjustment layers (12) are alternately deposited, and
a modification etching rate during electron beam modification of the protective layers (13) against gas permeation is higher than a modification etching rate of the phase difference and transmittance adjustment layers (12).

2. The phase shift mask blank according to claim 1,
wherein the phase shift film has resistance to oxygen-containing chlorine-based etching (Cl/O-based) and is etchable by fluorine-based etching (F-based).

3. The phase shift mask blank according to claim 1 or 2,
wherein the phase difference transmittance and adjustment layers contain silicon and contain at least one selected from transition metal, nitrogen, oxygen, and carbon, and
the transition metal is at least one selected from molybdenum, titanium, vanadium, cobalt, nickel, zirconium, niobium, and hafnium.

4. The phase shift mask blank according to claim 3,
wherein a film thickness of each of the phase difference and transmittance adjustment layers is 0.5 nm or more, and
a sum of film thicknesses of the phase difference and transmittance adjustment layers is more than a sum of film thicknesses of the protective layers against gas permeation.

5. The phase shift mask blank according to any one of claims 1 to 4,
wherein the protective layers against gas permeation contain at least one selected from tantalum metal, a tantalum compound, tungsten metal, a tungsten compound, tellurium metal, and a tellurium compound.

6. The phase shift mask blank according to claim 5,
wherein a film thickness of each of the protective layers against gas permeation is 0.5 nm or more, and
a sum of film thicknesses of the protective layers against gas permeation is 30 nm or less.

7. The phase shift mask blank according to claim 5 or 6,
wherein the tantalum compound contains tantalum and at least one selected from oxygen, nitrogen, and carbon.

8. The phase shift mask blank according to claim 5 or 6,
wherein the tungsten compound contains tungsten and at least one selected from oxygen, nitrogen, and carbon.

9. The phase shift mask blank according to claim 5 or 6,
wherein the tellurium compound contains tellurium and at least one selected from oxygen, nitrogen, and carbon.

10. phase shift mask blank according to any one of claims 1 to 9,
wherein an outermost layer of the phase shift film is the protective layer against gas permeation.

11. A phase shift mask (100) having a circuit pattern to which exposure light having a wavelength of 200 nm or less is applied, the phase shift mask (100) comprising:
a transparent substrate (11);
a phase shift film (14) formed on the transparent substrate (11); and
a light shielding film (15) formed on the phase shift film (14),
wherein the phase shift film (14) is a multi-layer phase shift film in which a plurality of phase difference and transmittance adjustment layers (12) that are capable of adjusting a predetermined amount of each of a phase and a transmittance with respect to exposure light to be transmitted and a plurality of protective layers (13) against gas permeation configured to prevent gas permeation to the phase difference and transmittance adjustment layers (12) are alternately deposited, and
a modification etching rate during electron beam modification of the protective layers (13) against gas permeation is higher than a modification etching rate of the phase difference and transmittance adjustment layers (12).

12. The phase shift mask according to claim 11,
wherein the phase shift film has resistance to oxygen-containing chlorine-based etching (Cl/O-based) and is etchable by fluorine-based etching (F-based).

13. The phase shift mask according to claim 11 or 12,
wherein the phase difference and transmittance adjustment layers contain silicon and contains at least one selected from transition metal, nitrogen, oxygen, and carbon, and
the transition metal is at least one selected from molybdenum, titanium, vanadium, cobalt, nickel, zirconium, niobium, and hafnium.

14. The phase shift mask according to claim 13,
wherein a film thickness of each of the phase difference and transmittance adjustment layers is 0.5 nm or more, and
a sum of film thicknesses of the phase difference and transmittance adjustment layers is more than a sum of film thicknesses of the protective layers against gas permeation.

15. The phase shift mask according to any one of claims 11 to 14,
wherein the protective layers against gas permeation contain at least one selected from tantalum metal, a tantalum compound, tungsten metal, a tungsten compound, tellurium metal, and a tellurium compound.

16. The phase shift mask according to claim 15,
wherein a film thickness of each of the protective layers against gas permeation is 0.5 nm or more, and
a sum of film thicknesses of the protective layers against gas permeation is 30 nm or less.

17. The phase shift mask according to claim 15 or 16,
wherein the tantalum compound contains tantalum and at least one selected from oxygen, nitrogen, and carbon.

18. The phase shift mask according to claim 15 or 16,
wherein the tungsten compound contains tungsten and at least one selected from oxygen, nitrogen, and carbon.

19. The phase shift mask according to claim 15 or 16,
wherein the tellurium compound contains tellurium and at least one selected from oxygen, nitrogen, and carbon.

20. The phase shift mask according to any one of claims 11 to 19,
wherein an outermost layer of the phase shift film is the protective layer against gas permeation.

21. A method for manufacturing a phase shift mask (100) using the phase shift mask blank (10) according to any one of claims 1 to 10, the method comprising:
forming a light shielding film (15) on the phase shift film (14);
forming a resist pattern (16) on the light shielding film (15);
forming a pattern on the light shielding film (15) by oxygen-containing chlorine-based etching (Cl/O-based) after forming the resist pattern (16);
forming a pattern on the phase shift film (14) by fluorine-based etching (F-based) after forming the pattern on the light shielding film (15);
removing the resist pattern (16) after forming the pattern on the phase shift film (14); and
removing the light shielding film (15) by oxygen-containing chlorine-based etching (Cl/O-based) from the phase shift film (14) after removing the resist pattern (16).

22. A method for modifying the phase shift mask (100) according to any one of claims 11 to 20 by electron beam modification etching, the method comprising:
surface-oxidizing each of the protective layers (13) against gas permeation immediately before modifying the protective layers (13) against gas permeation.

## Patentansprüche

1. Phasenschiebermaskenrohling (10), der zur Herstellung einer Phasenschiebermaske (100) verwendet wird, auf die Belichtungslicht, das eine Wellenlänge von 200 nm oder weniger aufweist, angewendet wird, wobei der Phasenschiebermaskenrohling (10) Folgendes umfasst:
ein transparentes Substrat (11);
ein Phasenverschiebungsfilm (14), der auf dem transparenten Substrat (11) gebildet ist; und
ein Lichtabschirmfilm (15), der auf dem Phasenverschiebungsfilm (14) gebildet ist,
wobei der Phasenverschiebungsfilm (14) ein mehrlagiger Phasenverschiebungsfilm ist, in dem eine Vielzahl von Schichten (12) zur Einstellung der Phasendifferenz und der Durchlässigkeit, die fähig sind, eine vorbestimmte Menge jeweils einer Phase und einer Durchlässigkeit in Bezug auf zu transmittierendes Belichtungslicht einzustellen, und eine Vielzahl von Schutzschichten (13) gegen Gaspermeation, die ausgebildet ist, Gaspermeation zu den Schichten (12) zur Einstellung der Phasendifferenz und der Durchlässigkeit zu verhindern, abwechselnd abgelagert sind, und
eine Modifikationsätzrate während der Elektronenstrahlmodifikation der Schutzschichten (13) gegen Gaspermeation höher ist als eine Modifikationsätzrate der Schichten (12) zur Einstellung der Phasendifferenz und der Durchlässigkeit.

2. Phasenschiebermaskenrohling nach Anspruch 1,
wobei der Phasenverschiebungsfilm eine Beständigkeit gegen sauerstoffhaltiges chlorbasiertes Ätzen (Cl/O-basiert) aufweist und durch fluorbasiertes Ätzen (F-basiert) ätzbar ist.

3. Phasenschiebermaskenrohling nach Anspruch 1 oder 2,
wobei die Schichten zur Einstellung der Phasendifferenz und der Durchlässigkeit Silizium enthalten und mindestens eines, ausgewählt aus Übergangsmetall, Stickstoff, Sauerstoff und Kohlenstoff, enthalten, und
das Übergangsmetall mindestens eines, ausgewählt aus Molybdän, Titan, Vanadium, Kobalt, Nickel, Zirkonium, Niob und Hafnium, ist.

4. Phasenschiebermaskenrohling nach Anspruch 3,
wobei eine Filmdicke jeder der Schichten zur Einstellung der Phasendifferenz und der Durchlässigkeit 0,5 nm oder mehr ist, und
eine Summe der Filmdicken der Schichten zur Einstellung der Phasendifferenz und der Durchlässigkeit mehr ist als eine Summe der Filmdicken der Schutzschichten gegen Gaspermeation.

5. Phasenschiebermaskenrohling nach einem der Ansprüche 1 bis 4,
wobei die Schutzschichten gegen Gaspermeation mindestens eines, ausgewählt aus Tantalmetall, einer Tantalverbindung, Wolframmetall, einer Wolframverbindung, Tellurmetall und einer Tellurverbindung, enthalten.

6. Phasenschiebermaskenrohling nach Anspruch 5,
wobei eine Filmdicke jeder der Schutzschichten gegen Gaspermeation 0,5 nm oder mehr ist, und
eine Summe der Filmdicken der Schutzschichten gegen Gaspermeation 30 nm oder weniger ist.

7. Phasenschiebermaskenrohling nach Anspruch 5 oder 6,
wobei die Tantalverbindung Tantal und mindestens eines, ausgewählt aus Sauerstoff, Stickstoff und Kohlenstoff, enthält.

8. Phasenschiebermaskenrohling nach Anspruch 5 oder 6,
wobei die Wolframverbindung Wolfram und mindestens eines, ausgewählt aus Sauerstoff, Stickstoff und Kohlenstoff, enthält.

9. Phasenschiebermaskenrohling nach Anspruch 5 oder 6,
wobei die Tellurverbindung Tellur und mindestens eines, ausgewählt aus Sauerstoff, Stickstoff und Kohlenstoff, enthält.

10. Phasenschiebermaskenrohling nach einem der Ansprüche 1 bis 9,
wobei eine äußerste Schicht des Phasenverschiebungsfilms die Schutzschicht gegen Gaspermeation ist.

11. Phasenschiebermaske (100), aufweisend ein Schaltungsmuster, auf das Belichtungslicht, das eine Wellenlänge von 200 nm oder weniger aufweist, angewendet wird, wobei die Phasenschiebermaske (100) Folgendes umfasst:
ein transparentes Substrat (11);
ein Phasenverschiebungsfilm (14), der auf dem transparenten Substrat (11) gebildet ist; und
ein Lichtabschirmfilm (15), der auf dem Phasenverschiebungsfilm (14) gebildet ist,
wobei der Phasenverschiebungsfilm (14) ein mehrlagiger Phasenverschiebungsfilm ist, in dem eine Vielzahl von Schichten (12) zur Einstellung der Phasendifferenz und der Durchlässigkeit, die fähig sind, eine vorbestimmte Menge jeweils einer Phase und einer Durchlässigkeit in Bezug auf zu transmittierendes Belichtungslicht einzustellen, und eine Vielzahl von Schutzschichten (13) gegen Gaspermeation, die ausgebildet ist, Gaspermeation zu den Schichten (12) zur Einstellung der Phasendifferenz und der Durchlässigkeit zu verhindern, abwechselnd abgelagert sind, und
eine Modifikationsätzrate während der Elektronenstrahlmodifikation der Schutzschichten (13) gegen Gaspermeation höher ist als eine Modifikationsätzrate der Schichten (12) zur Einstellung der Phasendifferenz und der Durchlässigkeit.

12. Phasenschiebermaske nach Anspruch 11,
wobei der Phasenverschiebungsfilm eine Beständigkeit gegen sauerstoffhaltiges chlorbasiertes Ätzen (Cl/O-basiert) aufweist und durch fluorbasiertes Ätzen (F-basiert) ätzbar ist.

13. Phasenschiebermaske nach Anspruch 11 oder 12,
wobei die Schichten zur Einstellung der Phasendifferenz und der Durchlässigkeit Silizium und mindestens eines, ausgewählt aus Übergangsmetall, Stickstoff, Sauerstoff und Kohlenstoff, enthalten, und
das Übergangsmetall mindestens eines, ausgewählt aus Molybdän, Titan, Vanadium, Kobalt, Nickel, Zirkonium, Niob und Hafnium, ist.

14. Phasenschiebermaske nach Anspruch 13,
wobei eine Filmdicke jeder der Schichten zur Einstellung der Phasendifferenz und der Durchlässigkeit 0,5 nm oder mehr ist, und
eine Summe der Filmdicken der Schichten zur Einstellung der Phasendifferenz und der Durchlässigkeit mehr ist als eine Summe der Filmdicken der Schutzschichten gegen Gaspermeation.

15. Phasenschiebermaske nach einem der Ansprüche 11 bis 14,
wobei die Schutzschichten gegen Gaspermeation mindestens eines, ausgewählt aus Tantalmetall, einer Tantalverbindung, Wolframmetall, einer Wolframverbindung, Tellurmetall und einer Tellurverbindung, enthalten.

16. Phasenschiebermaske nach Anspruch 15,
wobei eine Filmdicke jeder der Schutzschichten gegen Gaspermeation 0,5 nm oder mehr ist, und
eine Summe der Filmdicken der Schutzschichten gegen Gaspermeation 30 nm oder weniger ist.

17. Phasenschiebermaske nach Anspruch 15 oder 16,
wobei die Tantalverbindung Tantal und mindestens eines, ausgewählt aus Sauerstoff, Stickstoff und Kohlenstoff, enthält.

18. Phasenschiebermaske nach Anspruch 15 oder 16,
wobei die Wolframverbindung Wolfram und mindestens eines, ausgewählt aus Sauerstoff, Stickstoff und Kohlenstoff, enthält.

19. Phasenschiebermaske nach Anspruch 15 oder 16,
wobei die Tellurverbindung Tellur und mindestens eines, ausgewählt aus Sauerstoff, Stickstoff und Kohlenstoff, enthält.

20. Phasenschiebermaske nach einem der Ansprüche 11 bis 19,
wobei eine äußerste Schicht des Phasenverschiebungsfilms die Schutzschicht gegen Gaspermeation ist.

21. Verfahren zur Herstellung einer Phasenschiebermaske (100), unter Verwendung des Phasenschiebermaskenrohlings (10) nach einem der Ansprüche 1 bis 10, wobei das Verfahren umfasst:
Bilden eines Lichtabschirmfilms (15) auf dem Phasenverschiebungsfilm (14);
Bilden eines Resistmusters (16) auf dem Lichtabschirmfilm (15);
Bilden eines Musters auf dem Lichtabschirmfilm (15) durch sauerstoffhaltiges chlorbasiertes Ätzen (Cl/O-basiert) nach dem Bilden des Resistmusters (16);
Bilden eines Musters auf dem Phasenverschiebungsfilm (14) durch fluorbasiertes Ätzen (F-basiert) nach dem Bilden des Musters auf dem Lichtabschirmfilm (15);
Entfernen des Resistmusters (16) nach dem Bilden des Musters auf dem Phasenverschiebungsfilm (14); und
Entfernen des Lichtabschirmfilms (15) durch sauerstoffhaltiges chlorbasiertes Ätzen (Cl/O-basiert) von dem Phasenverschiebungsfilm nach dem Entfernen des Resistmusters (16).

22. Verfahren zum Modifizieren der Phasenschiebermaske (100) nach einem der Ansprüche 11 bis 20 durch Elektronenstrahl-Modifikationsätzen, wobei das Verfahren umfasst:
Oberflächenoxidieren jeder der Schutzschichten (13) gegen Gaspermeation unmittelbar vor dem Modifizieren der Schutzschichten (13) gegen Gaspermeation.

## Revendications

1. Ébauche (10) de masque à décalage de phase utilisée pour produire un masque (100) à décalage de phase auquel est appliquée une lumière d'exposition présentant une longueur d'onde de 200 nm ou moins, l'ébauche (10) de masque à décalage de phase comprenant :
un substrat (11) transparent ;
un film (14) à décalage de phase formé sur le substrat (11) transparent ; et
un film (15) de protection contre la lumière formé sur le film (14) à décalage de phase,
dans laquelle le film (14) à décalage de phase est un film à décalage de phase multicouche dans lequel une pluralité de couches (12) de réglage de différence de phase et de transmittance qui sont capables de régler une quantité prédéterminée de chacune d'une phase et d'une transmittance par rapport à une lumière d'exposition devant être transmise et une pluralité de couches de protection (13) contre une perméation de gaz configurées pour empêcher une perméation de gaz vers les couches (12) de réglage de différence de phase et de transmittance sont déposées alternativement, et
une vitesse de gravure de modification pendant une modification par faisceau d'électrons des couches (13) de protection contre une perméation de gaz est supérieure à une vitesse de gravure de modification des couches (12) de réglage de différence de phase et de transmittance.

2. Ébauche de masque à décalage de phase selon la revendication 1,
dans laquelle le film à décalage de phase présente une résistance à une gravure à base de chlore contenant de l'oxygène (à base de Cl/O) et peut être gravé par une gravure à base de fluor (à base de F).

3. Ébauche de masque à décalage de phase selon la revendication 1 ou la revendication 2,
dans laquelle les couches de réglage de différence de phase et de transmittance contiennent du silicium et contiennent au moins un sélectionné parmi un métal de transition, l'azote, l'oxygène et le carbone, et
le métal de transition est au moins un sélectionné parmi le molybdène, le titane, le vanadium, le cobalt, le nickel, le zirconium, le niobium et le hafnium.

4. Ébauche de masque à décalage de phase selon la revendication 3,
dans laquelle une épaisseur de film de chacune des couches de réglage de différence de phase et de transmittance est 0,5 nm ou plus, et
une somme d'épaisseurs de film des couches de réglage de différence de phase et de transmittance est supérieure à une somme d'épaisseurs de film des couches de protection contre une perméation de gaz.

5. Ébauche de masque à décalage de phase selon l'une quelconque des revendications 1 à 4,
dans laquelle les couches de protection contre une perméation de gaz contiennent au moins un sélectionné parmi le métal tantale, un composé de tantale, le métal tungstène, un composé de tungstène, le métal tellure, et un composé de tellure.

6. Ébauche de masque à décalage de phase selon la revendication 5,
dans laquelle une épaisseur de film de chacune des couches de protection contre une perméation de gaz est 0,5 nm ou plus, et
une somme d'épaisseurs de film des couches de protection contre une perméation de gaz est 30 nm ou moins.

7. Ébauche de masque à décalage de phase selon la revendication 5 ou la revendication 6,
dans laquelle le composé de tantale contient du tantale et au moins un sélectionné parmi l'oxygène, l'azote et le carbone.

8. Ébauche de masque à décalage de phase selon la revendication 5 ou la revendication 6,
dans laquelle le composé de tungstène contient du tungstène et au moins un sélectionné parmi l'oxygène, l'azote et le carbone.

9. Ébauche de masque à décalage de phase selon la revendication 5 ou la revendication 6,
dans laquelle le composé de tellure contient du tellure et au moins un sélectionné parmi l'oxygène, l'azote et le carbone.

10. Ébauche de masque à décalage de phase selon l'une quelconque des revendications 1 à 9,
dans laquelle une couche la plus extérieure du film à décalage de phase est la couche de protection contre une perméation de gaz.

11. Masque (100) à décalage de phase présentant un motif de circuit auquel est appliquée une lumière d'exposition présentant une longueur d'onde de 200 nm ou moins, le masque (100) à décalage de phase comprenant :
un substrat (11) transparent ;
un film (14) à décalage de phase formé sur le substrat (11) transparent ; et
un film (15) de protection contre la lumière formé sur le film (14) à décalage de phase,
dans lequel le film (14) à décalage de phase est un film à décalage de phase multicouche dans lequel une pluralité de couches (12) de réglage de différence de phase et de transmittance qui sont capables de régler une quantité prédéterminée de chacune d'une phase et d'une transmittance par rapport à une lumière d'exposition devant être transmise et une pluralité de couches (13) de protection contre une perméation de gaz configurées pour empêcher une perméation de gaz vers les couches (12) de réglage de différence de phase et de transmittance sont déposées alternativement, et
une vitesse de gravure de modification pendant une modification par faisceau d'électrons des couches (13) de protection contre une perméation de gaz est supérieure à une vitesse de gravure de modification des couches (12) de réglage de différence de phase et de transmittance.

12. Masque à décalage de phase selon la revendication 11,
dans lequel le film à décalage de phase présente une résistance à une gravure à base de chlore contenant de l'oxygène (à base de Cl/O) et peut être gravé par une gravure à base de fluor (à base de F).

13. Masque à décalage de phase selon la revendication 11 ou la revendication 12,
dans lequel les couches de réglage de différence de phase et de transmittance contiennent du silicium et contiennent au moins un sélectionné parmi un métal de transition, l'azote, l'oxygène et le carbone, et
le métal de transition est au moins un sélectionné parmi le molybdène, le titane, le vanadium, le cobalt, le nickel, le zirconium, le niobium et le hafnium.

14. Masque à décalage de phase selon la revendication 13,
dans lequel une épaisseur de film de chacune des couches de réglage de différence de phase et de transmittance est 0,5 nm ou plus, et
une somme d'épaisseurs de film des couches de réglage de différence de phase et de transmittance est supérieure à une somme d'épaisseurs de film des couches de protection contre une perméation de gaz.

15. Masque à décalage de phase selon l'une quelconque des revendications 11 à 14,
dans lequel les couches de protection contre une perméation de gaz contiennent au moins un sélectionné parmi le métal tantale, un composé de tantale, le métal tungstène, un composé de tungstène, le métal tellure, et un composé de tellure.

16. Masque à décalage de phase selon la revendication 15,
dans lequel une épaisseur de film de chacune des couches de protection contre une perméation de gaz est 0,5 nm ou plus, et
une somme d'épaisseurs de film des couches de protection contre une perméation de gaz est 30 nm ou moins.

17. Masque à décalage de phase selon la revendication 15 ou la revendication 16,
dans lequel le composé de tantale contient du tantale et au moins un sélectionné parmi l'oxygène, l'azote et le carbone.

18. Masque à décalage de phase selon la revendication 15 ou la revendication 16,
dans lequel le composé de tungstène contient du tungstène et au moins un sélectionné parmi l'oxygène, l'azote et le carbone.

19. Masque à décalage de phase selon la revendication 15 ou la revendication 16,
dans lequel le composé de tellure contient du tellure et au moins un sélectionné parmi l'oxygène, l'azote et le carbone.

20. Masque à décalage de phase selon l'une quelconque des revendications 11 à 19,
dans lequel une couche la plus extérieure du film à décalage de phase est la couche de protection contre une perméation de gaz.

21. Procédé de fabrication d'un masque (100) à décalage de phase
en utilisant l'ébauche (10) de masque à décalage de phase selon l'une quelconque des revendications 1 à 10, le procédé comprenant :
le formage d'un film (15) de protection contre la lumière sur le film (14) à décalage de phase ;
le formage d'un motif (16) de réserve sur le film (15) de protection contre la lumière ;
le formage d'un motif sur le film (15) de protection contre la lumière par gravure à base de chlore contenant de l'oxygène (à base de Cl/O) après formage du motif (16) de réserve ;
le formage d'un motif sur le film (14) à décalage de phase par gravure à base de fluor (à base de F) après formage du motif sur le film (15) de protection contre la lumière ;
le retrait du motif (16) de réserve après formage du motif sur le film (14) à décalage de phase ; et
le retrait du film (15) de protection contre la lumière par gravure à base de chlore contenant de l'oxygène (à base de Cl/O) du film à décalage de phase (14) après retrait du motif (16) de réserve.

22. Procédé de modification du masque (100) à décalage de phase selon l'une quelconque des revendications 11 à 20 par gravure de modification par faisceau d'électrons, le procédé comprenant :
l'oxydation en surface de chacune des couches (13) de protection contre une perméation de gaz immédiatement avant modification des couches (13) de protection contre une perméation de gaz.
